Europäisches Patentamt

European Patent Office

Office européen des brevets

(19)

(11) Veröffentlichungsnummer: **0 246 361 B1**

# (12) EUROPÄISCHE PATENTSCHRIFT

(45) Veröffentlichungstag der Patentschrift: 04.12.91

(51) Int. Cl.⁵: **H01H 47/22, H03K 17/24**

(21) Anmeldenummer: 86118017.2

(22) Anmeldetag: 23.12.86

(54) **Aus einem Akkumulator gespeistes und mittels Tastschalter ein- und ausschaltbares elektronisches Gerät.**

(30) Priorität: 24.04.86 DE 3613943

(43) Veröffentlichungstag der Anmeldung:
25.11.87 Patentblatt 87/48

(45) Bekanntmachung des Hinweises auf die
Patenterteilung:
04.12.91 Patentblatt 91/49

(84) Benannte Vertragsstaaten:
DE FR

(56) Entgegenhaltungen:
DE-B- 2 046 849
FR-A- 2 249 427
US-A- 3 609 390

ELEKTOR ELECTRONICS. vol. 9, no. 7/8, 1983,
CANTERBURY GB Seite 7-32 - 7-33; Siemens
Application: "power backup for CMOS ICs
during mains power failures"

(73) Patentinhaber: ROBERT BOSCH GMBH
Postfach 50
W-7000 Stuttgart 1(DE)

(72) Erfinder: Hahn, Michael
Lepsiusstrasse 8
W-1000 Berlin 41(DE)

(74) Vertreter: Schmidt, Hans-Ekhardt
Robert Bosch GmbH Geschäftsbereich Elektronik Patent- und Lizenzabteilung Forckenbeckstrasse 9-13
W-1000 Berlin 33(DE)

## Beschreibung

Die Erfindung geht von einem elektronischen Gerät nach der Gattung des Hauptanspruchs aus.

Es sind aus einem Akkumulator gespeiste elektronische Geräte bekannt, die durch Betätigen eines elektromechanischen Schalters ein- und ausschaltbar sind. Ist der Akkumulator zum Beispiel eine Kraftfahrzeugbatterie, so wird der Batterie beim Starten ein hoher Strom entnommen, der die Spannung derart absinken läßt, daß sie zum ordnungsgemäßen Betreiben eines ebenfalls aus der Kraftfahrzeugbatterie gespeisten elektronischen Gerätes, das ist beispielsweise ein Kraftfahrzeug-Funksende- und -empfangsgerät, nicht mehr ausreicht. Sofern das Gerät einen elektromechanischen Schalter, zum Beispiel einen Kippschalter, zum Ein- und Ausschalten der Stromversorgung aufweist, behält der Schalter auch beim Zusammenbrechen der Akkumulatorspannung seine Schaltstellung bei. Das Gerät ist dann sofort wieder betriebsbereit, wenn die Spannung zum Beispiel nach Beendigung des Startvorgangs wieder ansteigt. Es sind jedoch auch elektronische Geräte bekannt, bei denen mit einer Tipptaste in Verbindung mit einer Mikroprozessorschaltung das Gerät ein- und ausgeschaltet wird. Bei diesen Geräten muß nach einem Absinken und anschließenden Ansteigen der Speisespannung die Tipptaste erneut betätigt werden, um das Gerät wieder mit der Betriebsspannung zu versorgen.

## Vorteile der Erfindung

Das erfindungsgemäße elektronische Gerät mit den kennzeichnenden Merkmalen des Hauptanspruchs hat den Vorteil, daß kurze Stromausfälle keine Abschaltung des elektronischen Gerätes zur Folge haben. Eine erneute Betätigung eines Tastschalters nach einem Stromausfall kann somit entfallen. Als weiterer Vorteil ist anzusehen, daß der erforderliche zusätzliche Schaltungsaufwand verhältnismäßig gering ist. Schließlich ist auch von Vorteil, daß für die Ein- und Ausschaltung des elektronischen Gerätes getrennte Steuerleitungen vorgesehen sind und daß die Schaltung im abgeschalteten Zustand nahezu keinen Ruhestrom benötigt.

Durch die in den Unteransprüchen aufgeführten Maßnahmen sind vorteilhafte Weiterbildungen und Verbesserungen des im Hauptanspruch angegebenen elektronischen Gerätes möglich.

## Zeichnung

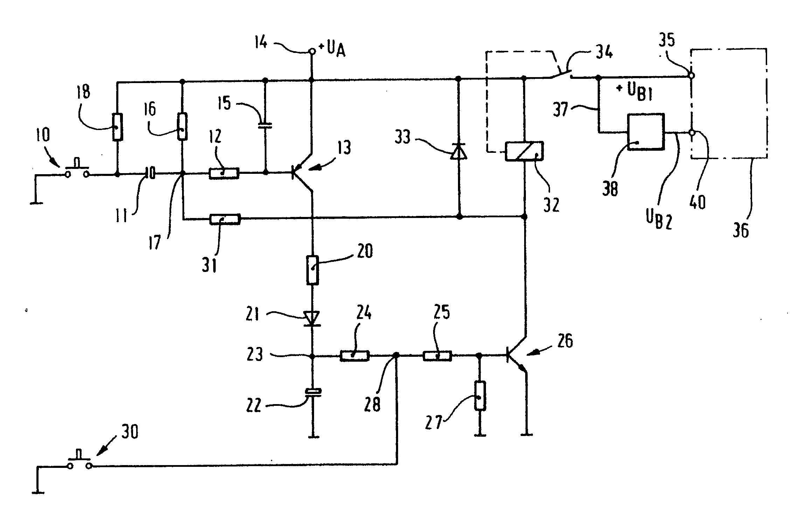

Ein Ausführungsbeispiel der Erfindung ist in der Zeichnung anhand einer einzigen Figur dargestellt und in der nachfolgenden Beschreibung näher erläutert.

## Beschreibung der Erfindung

In der einzigen Figur bezeichnet 10 einen ersten Tastschalter, der eine Einschalttaste bildet, die die Verbindung zwischen dem Bezugspotential und einem Kondensator 11 herstellt. Der Kondensator 11 ist über einen Widerstand 12 mit der Basis eines ersten Transistors 13 verbunden. Der Emitter des ersten Transistors ist erstens mit einem Anschluß 14 verbunden, der mit dem positiven Pol eines Akkumulators, das ist vorzugsweise eine Kraftfahrzeugbatterie, in Verbindung steht, zweitens über einen Kondensator 15 mit der Basis des ersten Transistors 13, drittens über einen Widerstand 16 mit einem Schaltungspunkt 17 zwischen dem Kondensator 11 und dem Widerstand 12 und viertens über einen Widerstand 18 mit dem dem Tastschalter 10 zugewandten Anschluß des Kondensators 11. Der Kollektor des ersten Transistors 13 ist über eine Reihenschaltung aus einem Widerstand 20, einer ersten Diode 21 und einem Ladekondensator 22 mit Masse verbunden. Ein weiterer Schaltungspunkt 23 zwischen der ersten Diode 21 und dem Ladekondensator 22 steht über zwei in Reihe geschaltete Widerstände 24 und 25 mit der Basis eines zweiten Transistors 26 in Verbindung. Zwischen der Basis des zweiten Transistors 26 und Masse liegt ein Widerstand 27 und zwischen einem Schaltungspunkt 28 zwischen beiden Widerständen 24 und 25 und Masse ein zweiter Tastschalter 30. Während der Emitter des zweiten Transistors 26 auf dem Massepotential liegt, steht dessen Kollektor erstens über einen Widerstand 31 mit dem Schaltungspunkt 17 und zweitens über ein Relais 32, das durch eine Diode 33 überbrückt ist, mit dem Anschluß 14 in Verbindung. Von dem Anschluß 14 führt eine weitere Verbindung über einen im Ruhezustand geöffneten Schalter 34 des Relais 32 an einen ersten Versorgungsspannungsanschluß 35 einer elektrischen Schaltung 36 des elektronischen Gerätes. Zwischen dem Schalter 34 und dem Anschluß 35 zweigt eine Leitung 37 ab, die über einen Spannungsregler 38 mit einem zweiten Versorgungsspannungsanschluß 40 der elektrischen Schaltung 36 in Verbindung steht.

Die Wirkungsweise der vorstehend beschriebenen Schaltung ist folgende:

Im Ruhezustand sind die beiden Tastschalter 10 und 30 geöffnet, die Transistoren 13 und 26 gesperrt, das Relais 32 stromlos und der Schalter 34 des Relais 32 geöffnet. An den Anschlüssen 35 und 40 der elektrischen Schaltung 36 liegen somit keine Versorgungsspannungen.

Soll das elektronische Gerät eingeschaltet werden, so geschieht dies durch kurzzeitiges Betätigen des Tastschalters 10 (Einschalttaste). Dadurch fließt ein Strom von dem positiven Anschluß 14 über ein Differenzierglied aus dem Widerstand 16 und dem Kondensator 11 nach Masse. Ein dadurch entstehender Impuls gelangt über den Widerstand 12 an die Basis des ersten Transistors 13, der für die Impulsdauer in den leitenden Zustand gesteuert wird. Damit kann sich der Ladekondensator 22 über die Kollektor-Emitterstrecke des ersten Transistors 13, den Widerstand 20 und die in Durchlaßrichtung gepolte Diode 21 aufladen. Die Kondensatorspannung steuert über die Widerstände 24 und 25 den zweiten Transistor 26 in den leitenden Zustand, so daß über die Kollektor-Emitterstrecke dieses Transistors ein Erregerstrom für das Relais 32 fließt und der zugehörige Schalter 34 geschlossen wird. Über den Widerstand 31, 12 und den Transistor 26 fließt außerdem der Basisstrom des Transistors 13, der damit ständig leitet. Bei geschlossenem Schalter 34 steht an dem ersten Versorgungsspannungsanschluß 35 eine Spannung $U_{B1}$ und an dem zweiten Stromversorgungsanschluß 40 eine geregelte Spannung $U_{B2}$ zur Verfügung. Diese Spannungen und gegebenenfalls noch weitere Spannungen dienen zur Stromversorgung der elektrischen Schaltung 36 des elektronischen Gerätes.

Sinkt aus irgendeinem Grunde die Spannung $U_A$ stark ab, zum Beispiel beim Betätigen des Starters eines Kraftfahrzeuges, so bleibt auch in diesem Fall der Transistor 26 für eine bestimmte Zeit leitend. Das Relais 32 erhält dann zwar keinen Erregerstrom aus der Kraftfahrzeugbatterie mehr, so daß der Schalter 34 öffnet; sobald aber die Spannung $U_A$ wieder ansteigt, wird das Relais 32 erregt, der Schalter 34 geschlossen und die elektrische Schaltung 36 mit Strom versorgt.

Zum Ausschalten des elektronischen Gerätes bzw. der Betriebsspannungen $U_{B1}$, $U_{B2}$ wird der Tastschalter 30 betätigt, wodurch der Kondensator 22 durch den Widerstand 24 überbrückt, der zweite Transistor 26 gesperrt, das Relais 32 stromlos und der Schalter 34 geöffnet werden. Das Ausschalten des elektronischen Gerätes erfolgt also nur willentlich durch Betätigen des zweiten Tastschalters 30. Von der Dimensionierung des Ladestromkreises für den Kondensator 22 hängt es ab, wie lange die Akkumulatorspannung $U_A$ absinken oder ganz ausfallen darf, ohne daß die Transistoren 13 und 26 gesperrt werden und ein automatisches Wiedereinschalten des elektronischen Gerätes verhindern.

**Patentansprüche**

1.  Aus einem Akkumulator gespeistes und mit einem Tastschalter (10,30) ein- und ausschaltbares elektronisches Gerät (36), dadurch gekennzeichnet, daß ein einen Einschalter bildender erster Tastschalter (10) bei kurzzeitiger Betätigung einen von der Akkumulatorspannung ($U_A$) gespeisten Ladestromkreis für einen Kondensator (22) schließt, daß die bei zumindest teilweise aufgeladenem Kondensator vorhandene Kondensatorspannung die Erregung eines Relais (32) auslöst, daß bei erregtem Relais ein von diesem gesteuerter Schalter (34) eine Verbindung zwischen dem Akkumulator und einem Speisespannungsanschluß (35) für die elektrische Schaltung (36) des elektronischen Gerätes herstellt und einen Haltestromkreis (31, 12, 13) für das Relais schließt und daß ein einen Ausschalter bildender zweiter Tastschalter (30) vorgesehen ist, der bei Betätigung einen den Kondensator (22) entladenden Stromkreis schließt, durch den das Relais (32) stromlos gemacht und der Schalter (34) geöffnet wird.

2.  Elektronisches Gerät nach Anspruch 1, dadurch gekennzeichnet, daß der Kondensator (22) mit einem Anschluß auf einem Bezugspotential und mit dem anderen Anschluß über eine erste Diode (21) und die Kollektor-Emitterstrecke eines ersten Transistors (13) mit dem positiven Pol (16) des Akkumulators verbunden ist und daß die Basis des ersten Transistors über den ersten Tastschalter (10) mit dem Bezugspotential verbunden ist.

3.  Elektronisches Gerät nach Anspruch 1, dadurch gekennzeichnet, daß das Relais (32) zwischen dem positiven Pol (16) des Akkumulators und der Kollektor-Emitterstrecke eines zweiten Transistors (26) liegt, dessen Emitter mit dem Bezugspotential und dessen Basis mit dem Kondensator (22) verbunden ist.

**Claims**

1.  Electronic device (36), which is supplied by a storage battery and can be switched on and off by a push-button switch (10, 30), characterised in that, when actuated for a short time, a first push-button switch (10), which forms a circuit closer, closes a charging circuit, which is supplied by the storage battery voltage ($U_A$), for a capacitor (22), in that the capacitor voltage present, given at least a partially charged capacitor, triggers the energisation of a relay (32),in that, when the relay is energised, a switch (34), which is controlled by the relay, creates a connection between the storage battery and a supply voltage connection (35) for the electric circuit (36) of the electronic device and closes a holding circuit (31, 12, 13) for the relay, and in that a second push-button switch (30) is provided which forms a circuit breaker and which, on actuation, closes an electric circuit, which discharges the capacitor (22) and through which the relay (32) is made currentless and the switch (34) opened.

2. Electronic device according to claim 1, characterised in that the capacitor (22) is connected by one terminal to a reference potential and by the other terminal by way of a first diode (21) and the collector-emitter path of a first transistor (13) to the positive pole (16) of the storage battery, and in that the base of the first transistor is connected by way of the first push-button switch (10) to the reference potential.

3. Electronic device according to claim 1, characterised in that the relay (32) lies between the positive pole (16) of the storage battery and the collector-emitter path of a second transistor (26), whose emitter is connected to the reference potential and whose base is connected to the capacitor (22).

**Revendications**

1. Appareil électronique (36) alimenté à partir d'un accumulateur et pouvant être branché et débranché au moyen de touches à affleurement (10, 30), appareil caractérisé en ce qu'une première touche à effleurement (10) formant une touche de fermeture de circuit, ferme lors d'un bref actionnement, un circuit de charge d'un condensateur (22), circuit alimenté par la tension ($U_A$) de l'accumulateur, en ce que la tension disponible du condensateur, lorsque le condensateur est chargé au moins partiellement, excite un relais (32), en ce que, quand le relais est excité, un interrupteur (34) commandé par celui-ci, établit une liaison entre l'accumulateur et un pôle de tension d'alimentation (35) pour le circuit électrique (36) de l'appareil électronique et ferme un circuit de courant de repos (31, 12, 13) pour le relais et en ce qu'il est prévu une deuxième touche à effleurement (30) formant une touche d'ouverture de circuit, touche qui, lors de son actionnement, ferme un circuit déchargeant le condensateur (22), circuit au moyen duquel le relais (32) est privé de courant et l'interrupteur (34) est ouvert.

2. Appareil électronique selon la revendication 1, caractérisé en ce que le condensateur (22) est relié par une borne au potentiel de référence et par l'autre borne, via une première diode (21) et le trajet collecteur-émetteur d'un premier transistor (13) au pôle positif (16) de l'accumulateur et en ce que la base du premier transistor est reliée via la première touche à effleurement (10) au potentiel de référence.

3. Appareil électronique selon la revendication 1, caractérisé en ce que le relais (32) se trouve entre le pôle positif (16) de l'accumulateur et le trajet collecteur-émetteur d'un deuxième transistor (26), dont l'émetteur est relié au potentiel de référence et dont la base est reliée au condensateur (22).